# EUROPÄISCHE PATENTANMELDUNG

(11) **EP 1 067 601 A1**
(43) Veröffentlichungstag der Anmeldung: **10.01.2001**
(21) Anmeldenummer: 00114407.0
(22) Anmeldetag: 05.07.2000
(51) Int. Cl.: H01L 23/14

(54) **Chipmodul, insbesondere BGA-Package, mit einem Interconnect zur stressfreien Lötverbindung mit einer Leiterplatte**

(30) Priorität: 05.07.1999 DE 19931004
(71) Anmelder: Tyco Electronics Logistics AG, 9323 Steinach / SG (CH)
(72) Erfinder: Hedler, Harry, 93049 Regensburg (DE)
(74) Vertreter: Heinz-Schäfer, Marion

(57) **Zusammenfassung**

Das Interconnect (3) besteht in lateraler Richtung, also parallel zur Leiterplatte (7), aus Bereichen (A, B, C) mit unterschiedlichen linearen Längenausdehnungskoeffizienten, die in ihrer lateralen Ausdehnung so aufeinander abgestimmt sind, daß die resultierende Längenausdehnung des Interconnect (3) der Längenausdehnung der Leiterplatte (3) entspricht. Dadurch wird der thermische Mismatch zwischen Chip (1) und Leiterplatte (7) ausgeglichen.

## Beschreibung

Die Erfindung betrifft ein Chipmodul, insbesondere ein BGA-Package, mit einem Interconnect.

Beim Aufbau komplexer elektronischer Systeme mit (mehreren) Halbleiterchips rücken im Zuge der Verringerung der Chipanschluß-Abstände zunehmend Probleme der Verbindungs- und Packaging-Technologie in den Vordergrund. Der konventionelle Aufbau, bei dem die Chips individuell gehäust, mit Anschlüssen versehen und anschließend einzeln auf eine Leiterplatte bestückt werden, ist wegen des relativ hohen Platzbedarfs und wegen der erforderlichen Verdrahtung zwischen den einzelnen Chips in vielen Fällen nicht optimal.

Zunehmend üblich ist deshalb der Systemaufbau in Form von Multichipmodulen, bei denen ein Substrat mit einer hochdichten Mehrlagenverdrahtung, auf dem die Chips angebracht sind, als Zwischenträgersubstrat (Interconnect) für eine gemeinsame Integration mehrerer Chips in eine nächsthöhere Architekturebene des Systemaufbaus dient. Als Material für das Substrat des Interconnect kommen neben dem konventionellen Kunststoff heute vor allem Keramik, Metall und Silicium in Frage. Silicium und Keramik sind jedoch problematisch hinsichtlich der Kombination mit der platzsparenden Verbindungstechnik BGA (Ball Grid Array), da die erforderlichen Bohrungen für die Durchkontaktierung von der Mehrlagenverdrahtung auf der Bestückungsseite zu den flächig angeordneten Lotballungen auf der Unterseite beispielsweise für ein Keramiksubstrat nur schwer herstellbar sind.

Besondere Probleme stellen sich bei der Herstellung von ultra flachen Packages für Einzelchip- und Multichip-Anwendungen. Das derzeitige Verhältnis von Leistungsfähigkeit und Flexibilität solcher Packages zu den Herstellungskosten ist unbefriedigend. Insbesondere steht man bei der Direktmontage von Chips auf dem Board heute vor folgender Problemsituation:

Der Längenausdehnungskoeffizient (CTE) der Si-Chips beträgt ungefähr 3-4ppm/K, während der CTE des Boards (FR4, FR5, BT...) ca. 15-16ppm/K beträgt.

Eine face down Montage der Si-Chips als Flipchip direkt auf das Board führt deshalb wegen der erhebliche Differenz der Längenausdehnungskoeffizienten von etwa 12ppm/K zu Abrissen der Lotballs beim Temperaturwechseltest. Ein Beispiel: Ein 10mm langer Si-Chip erzeugt bei einer Temperaturänderung von 250°C einen Misfit gegenüber dem Board von 30µm (Löttemperatur ca. 180°C; unterste Temperatur im Wechseltest -40°C bis - 60°C). Das führt dazu, daß jene Solder Balls, welche am weitesten vom Chipzentrum entfernt sind, in der Mitte abgeschert werden.

Um dem thermischen Mismatch entgegen zu wirken, sind Aufbauten bekannt, welche in entsprechenden Anordnungen Ebenen unterhalb des Chip, innerhalb des Package, einführen, die diese Fehlanpassung also über einen Lagenaufbau in die senkrechte Richtung ausgleichen sollen. Die konventionellen Lösungen arbeiten vorwiegend mit einem homogenen, massiven Träger (Laminat: FR4, FR5, BT...), welcher in allen Bereiche unterhalb des Chips und der Umhüllung gleichermaßen vorliegt.

Diese bekannten Lösungen führen allerdings zu komplexen Aufbauten, welche nicht nur teuer sind, sondern auch die Bauhöhe vergrößern.

Aus der Patentschrift US 5,821,608 ist außerdem ein spezielles Aufbau- und Verbindungssystem für ein Chip-Package bekannt geworden, das auf einem lateralen Ausgleich der Temperaturausdehnungen beruht. Vorgeschlagen wird dort ein inneres und äußeres Substrat (kein Interconnect), die über in lateraler Richtung dehnbare Federdrähte verbunden sind.

Ziel der vorliegenden Erfindung ist es, ein gegenüber den genannten Nachteilen verbessertes Chipmodul zu schaffen.

Erfindungsgemäß wird diese Ziel erreicht durch ein Chipmodul
- mit einem Interconnect, der ein Trägersubstrat und eine Mehrlagenverdrahtung umfaßt,
- mit mindestens einem auf dem Interconnect angeordneten Halbleiterchip,
- und mit am Interconnect angeordneten Lötkontakten, die zur elektrischen Verbindung des Chipmoduls mit einer Leiterplatte aus Kunststoff dienen,
- bei dem das Interconnect in lateraler Richtung, also parallel zur Leiterplatte, aus Bereichen mit unterschiedlichen linearen Längenausdehnungskoeffizienten besteht,
- die in ihrer lateralen Ausdehnung so aufeinander abgestimmt sind, daß die resultierende Längenausdehnung des Interconnect der Längenausdehnung der Leiterplatte entspricht.

Der erfindungsgemäße Gedanke zeigt eine Bauform auf, welche das Problem der thermischen Fehlanpassung durch entsprechende Materialwahl und Dimensionierung des High Density Interconnect löst. Der Ausgleich des CTE erfolgt in der Ebene (des Interconnect), also lateral. Es können damit sehr kleine und sehr flache (Body Height = Chip Height) BGA, CSP und MCM in Flipchip-Ausführung aufgebaut werden, welche ohne temperaturinduzierten Streß auf einem Leiterplatten-Board montiert werden können. Dabei sind nur wenige Technologieschritte erforderlich. Das Wirkungsprinzip beruht auf der gezielten Auswahl von Materialsystemen, welche eine gewünschte Längenausdehnung (nämlich die des Boards) in der Summe einstellt (Kompensationsprinzip).

Weiterbildungen der Erfindung sind Gegenstand der Unteransprüche.

Die Erfindung wird nachfolgend an Ausführungsbeispielen anhand der Zeichnungen näher erläutert. Es zeigt:
- Figur 1: einen schematischen seitlichen Schnitt eines erfindungsgemäßen Chipmoduls,
- Figur 2 bis 5: in gleicher Darstellung, jeweils eine weitere Ausführungsform eines Chipmoduls gemäß der Erfindung.

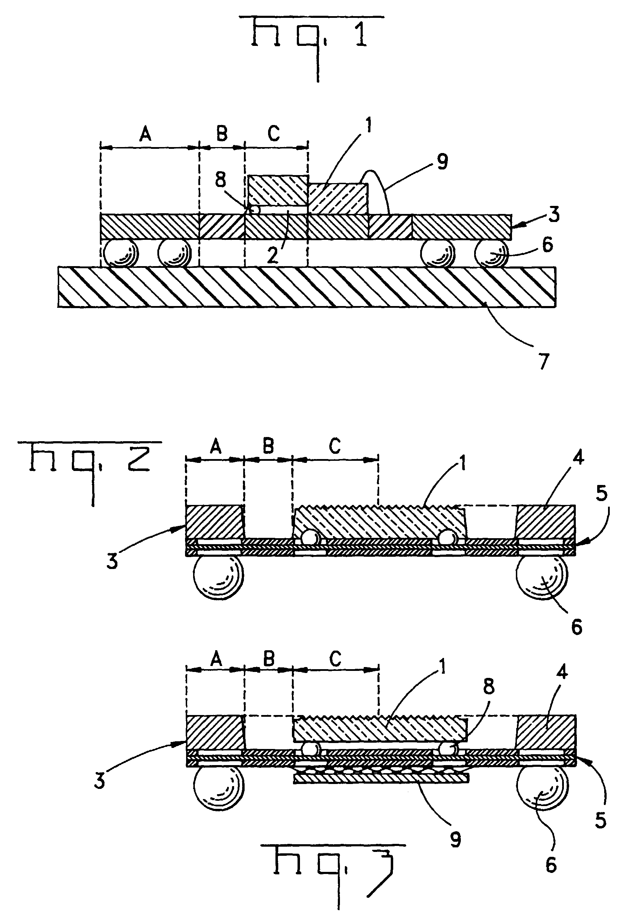

Der prinzipielle Aufbau ist in Figur 1 dargestellt.

### Region C:

Der Chip 1 ist via Underfill 2 fest auf dem Interconnect 3 befestigt (Flip Chip) oder er ist, vgl. den rechten Teil der Figur, auf den Interconnect 3 geklebt (Wire Bond 9). Der Interconnect 3 unter dem Chip, Region C, ist dünn und elastisch und folgt der Längenausdehnung des Chips 1. Das Gebiet C unterhalb des Chips 1 hat einen typischen CTE vom Chip 1 selbst (ca. 3-4ppm/K).

### Region A:

Der Interconnect-Rahmen A besteht aus einem Werkstoff mit dem CTE des Boards 7. Bevorzugtes Material hierfür ist Kupfer (CTE ca. 15ppm/K).

### Region B (Kompensationsgebiet):

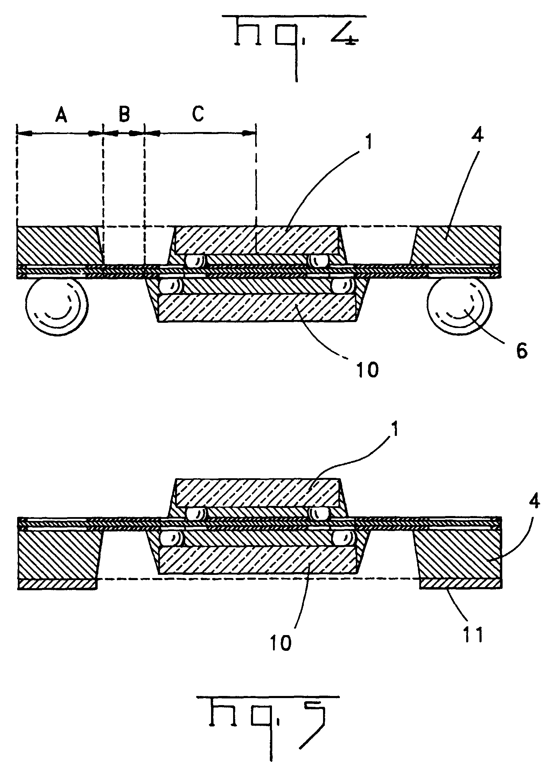

Der Interconnect B (ohne Trägermaterial) hat einen erheblich größeren Längenausdehnungskoeffizienten. Er besteht z.B. aus Polyimid, PBO oder aus einem Epoxidharz (CTE ca. 40-60ppm/K). Auch kann die Mehrlagenverdrahtung 5, vgl. Figur 2 bis 5, des Interconnect selbst als dünnes Flex an die Moldmasse des Chipmodul-Gehäuses direkt angeklebt sein (CTE ca. 20-60ppm/K).

Im einzelnen besteht der erfindungsgemäße Gedanke der Kompensation des CTE-Mismatch in folgendem:

Betrachtet man den Unterschied der CTE der drei Regionen im Vergleich zum Board 7, so soll die infolge des geringeren CTE zu geringe Ausdehnung der Chipregion C durch die -relativ zu große- Ausdehnung des Kompensationsgebiets B ausgeglichen werden. Sind beide Ausdehnungsbeträge gleich groß, laßt sich eine Stressfreiheit an den Lotballs zum Board 7 einstellen.

Realisierbar ist diese Kompensation der thermischen Ausdehnung (in Bezug aus die Board-Ausdehnung) beispielsweise durch folgende Anordnung:
Region A: Kupfer, (CTE ca. 15-16ppm/K)
   Nach der Aufbringung des Interconnect 3 ist in der Mitte, C, das Cu entfernt. Die Größe des Ringes ist beliebig. Werden die Lotballs 6 mehrzeilig ausgeführt, so ist die Nutzung eines derartigen Ringes mit Stressfreiheit zum Board eine geeignete Lösung.
Region C: Si-Chip-Gebiet, (CTE ca. 3-4ppm/K); Flip Chip:
   Chip 1 ist (eventuell) durch Underfill 2 gesichert, oder durch eine aufgeklebte Gegenplatte 10 (vgl. Figur 3) auf der Interconnect - Unterseite (gleiche Größe, gleicher CTE wie der Chip 1, z. B. Keramik; CTE ca. 6ppm/K). Wire Bond: Chip 1 ist auf Interconnect 3 geklebt.
Region B (Kompensationsgebiet, Interconnect ohne Trägermaterial):
   Polyimid, PBO, Harz,... (CTE ca. 60ppm/K) Die notwendige Länge von B zum Erreichen der Stressfreiheit hängt von der Chipgröße ab. Für einen CTE von 60ppm/K entspricht die Kompensationslänge ca. 1/8 der Si- Chiplänge.

Figur 2 zeigt beispielsweise einen Halbleiterchip 1, der mit seiner aktiven Seite mittels Lotkügelchen 8 auf der ersten, obersten Leiterbahnebene der Mehrlagenverdrahtung 5 verlötet ist, die in an sich bekannter Weise als eine Sequenz von strukturierten Metallebenen, die durch ein organisches Dielektrikum elektrisch voneinander getrennt sind, ausgebildet ist. Dabei werden beispielsweise über lithographisch erzeugte Via Holes im Dielektrikum gezielt Verbindungen zwischen den Leiterbahnebenen hergestellt. Bevorzugt wird eine Mehrlagenverdrahtung mit alternierenden Cu-BCB-(Diphenylcyclobuthen)-Ebenen. Die Mehrlagenverdrahtung 5 hat eine typische Dicke von ca. 50 µm.

In Figur 4 ist ein Chipmodul dargestellt, bei dem als Gegenplatte ein weiterer Chip 10 vorgesehen ist. Figur 5 stellt ein ähnliches Chipmodul wie in Figur 4, jedoch mit flächigen Lötkontakten 11 dar.

## Patentansprüche

1. Chipmodul, insbesondere BGA-Package,
- mit einem Interconnect (3), der ein Trägersubstrat (4) und eine Mehrlagenverdrahtung (5) umfaßt,
- mit mindestens einem auf dem Interconnect (3) angeordneten Halbleiterchip (1),
- und mit am Interconnect (3) angeordneten Lötkontakten (6, 11), die zur elektrischen Verbindung des Chipmoduls mit einer Leiterplatte (7) aus Kunststoff dienen,
- bei dem das Interconnect (3) in lateraler Richtung, also parallel zur Leiterplatte (7), aus Bereichen mit unterschiedlichen linearen Längenausdehnungskoeffizienten besteht,
- die in ihrer lateralen Ausdehnung so aufeinander abgestimmt sind, daß die resultierende Längenausdehnung des Interconnect (3) der Längenausdehnung der Leiterplatte (7) entspricht.

2. Chipmodul nach Anspruch 1,
**dadurch gekennzeichnet**,
daß das Material des Trägersubstrats (4) unterhalb des Chips (1) entfernt ist und somit zwei Bereiche unterschiedlicher Längenausdehnung entstehen.

3. Chipmodul nach Anspruch 1,
**dadurch gekennzeichnet**,
daß das Material des Trägersubstrats (4) sowohl unterhalb des Chipgebietes entfernt ist als auch, daran anschließend, noch zusätzlich in einem Abstand zum Chip entfernt ist und somit drei Bereiche (A, B, C) unterschiedlicher Längenausdehnung entstehen: einer (C) direkt unterhalb des Chip, einer (B) im Anschluß neben dem Chip (1) und ein dritter (A) als Trägersubstrat-Rahmen.

4. Chipmodul nach Anspruch 3,
**dadurch gekennzeichnet**,
daß der mittlere Bereich (B) einen Längenausdehnungskoeffizienten besitzt, welcher größer ist als der des Chipbereiches (C) und der des Trägersubstrat-Rahmens (A).

5. Chipmodul nach Anspruch 4,
**dadurch gekennzeichnet**,
daß der Trägersubstrat-Rahmen (A) die Längenausdehnung der Leiterplatte (7), und der Chipbereich (C) die Längenausdehnung des Chips (1) besitzt und daß somit der mittlere Bereich (B) ein Kompensationsgebiet bildet.

6. Chipmodul nach einem der Ansprüche 1 bis 5,
**dadurch gekennzeichnet**,
daß das Trägersubstrat (4) aus Kupfer besteht oder aus Legierungen, welche diesen Stoff enthalten.

7. Chipmodul nach einem der Ansprüche 3 bis 6,
**dadurch gekennzeichnet**,
daß das Material des B-Bereiches des Interconnect (3) aus Polyimid, PBO, BCB oder Epoxydharz besteht.

8. Chipmodul nach einem der Ansprüche 3 bis 7,
**dadurch gekennzeichnet**,
daß die Lötkontakte in Form von Lotkugeln (6) in mehrzeiliger BCA-Ausführung ausgebildet sind, und daß die Lotkugeln (6) auf dem Trägersubstrat-Rahmen (A) montiert sind.

9. Chipmodul nach einem der Ansprüche 1 bis 8,
**dadurch gekennzeichnet**,
daß der Chip (1) in Flip-Chip-Technik mittels Lotkügelchen (8) auf dem Interconnect (3) angeordnet, und daß zur Sicherung des Chips (1) auf dem Interconnect (3) anstelle von Underfill (2) auf der Unterseite des Interconnect (3) eine Gegenplatte (9) montiert ist.

10. Chipmodul nach Anspruch 9,
**dadurch gekennzeichnet**,
daß die Gegenplatte (9) aus Metall oder Keramik besteht.

11. Chipmodul nach Anspruch 9,
**dadurch gekennzeichnet**,
daß als Gegenplatte (9) ein weiterer Chip (10) montiert ist.
